# EUROPÄISCHE PATENTSCHRIFT

(11) **EP 0 719 474 B1**
(45) Veröffentlichungstag und Bekanntmachung des Hinweises auf die Patenterteilung: **24.11.1999**
(21) Anmeldenummer: 94925350.4
(22) Anmeldetag: 07.09.1994
(51) Int. Cl.: H03F 3/30, H03F 3/45

(54) **BiCMOS-OPERATIONSVERSTÄRKER FÜR SCHALTER-KONDENSATOR-SCHALTUNGEN**
BiCMOS OPERATIONAL AMPLIFIER FOR SWITCH-CAPACITOR CIRCUITS
AMPLIFICATEUR OPERATIONNEL BiCMOS POUR MONTAGES DE COMMUTATEURS ET CONDENSATEURS

(30) Priorität: 15.09.1993 DE 4331362
(43) Veröffentlichungstag der Anmeldung: 03.07.1996
(73) Patentinhaber: SIEMENS AKTIENGESELLSCHAFT, 80333 München (DE)
(72) Erfinder: NEBEL, Gerhard, D-87509 Immenstadt (DE); GEORGAKOS, Georg, D-85447 Fraunberg (DE); KLEINE, Ulrich Dr., D-82008 Unterhaching (DE)
(86) Internationale Anmeldenummer: DE9401027
(87) Internationale Veröffentlichungsnummer: WO9508215

(56) Entgegenhaltungen:
- EP-A- 0 358 266
- US-A- 3 644 838
- IEEE JOURNAL OF SOLID-STATE CIRCUITS., Bd.26, Nr.3, März 1991, NEW YORK US Seiten 203 - 208, XP222596 A.N. KARANICOLAS ET AL 'A HIGH-FREQUENCY FULLY DIFFERENTIAL BICMOS OPERATIONAL AMPLIFIER'
- 1993IEEE INTERNATIONAL SYMPOSIUM ON CIRCUITS AND SYSTEMS, Bd.2, 3. Mai 1993, CHICAGO, IL Seiten 1136 - 1139, XP379173 S. SEN ET AL 'A LOW-POWER CLASS-AB BICMOS OPAMP USING PSEUDO-PNP TRANSISTORS'
- ELECTRONICS LETTERS., Bd.24, Nr.2, 21. Januar 1988, ENAGE GB Seiten 89 - 90 T. KINOSHITA ET AL 'HIGH GAIN WIDEBAND AMPLIFIER IC USING 0.7MICROM. GAAS MESFET TECHNOLOGY'

## Beschreibung

Früher wurden integrierte Operationsverstärker für Schalter-Kondensator (SC-)-Schaltungen in reiner CMOS-Technik realisiert. Diese Schaltungen benötigen aber mehr Chipfläche und sind in der Regel aufwendiger als BiCMOS-Verstärker. Durch die besseren Analogeigenschaften bezüglich Steilheit und Ausgangswiderstand eines Bipolartransistors gegenüber einem MOS-transistor können mit BiCMOS-Verstärkern höhere Bandbreiten und höhere Ausgangswiderstände erzielt werden. Durch die zusätzliche verwendung von Bipolartransistoren, die eine höhere Steilheit als MOS-Transistoren aufweisen, können Verstärker mit hoher Bandbreite und hoher Verstärkung wesentlich einfacher und mit geringerem Flächenbedarf realisiert werden. MOS-Transistoren sind spannungsgesteuerte Bauelemente, Bipolartransistoren dagegen stromgesteuerte Bauelemente. Bei der Ankopplung von bipolaren Transistoren an eine MOS-Verstärkerstufe sind daher besondere Schaltungstechnik erforderlich, um, auch bei Schwankungen im Herstellungsprozeß, die Arbeitspunkte der Bipolartransistoren sicherzustellen.

Aus dem IEEE Journal Of Solid-State Circuits, Bd. 26, Nr. 3, März 1991, New York US, Seiten 203 bis 208 ist ein gattungsgemäßer Operationsverstärker bekannt.

Ferner ist aus der amerikanischen Patentschrift US-A-3 644 838 ein Operationsverstärker bekannt, bei dem zur Vergrößerung der Übertragungsbandbreite anstelle eines lateralen Bipolartransistors ein IGFET verwendet wird.

Die der Erfindung zugrundeliegende Aufgabe besteht nun darin, einen BiCMOS-Operationsverstärker anzugeben, der einen hohen Eingangswiderstand sowie eine hohe Bandbreite aufweist, der sich besonders für SC-Schaltungen eignet und der vor allem die Einhaltung der Arbeitspunkte der bipolaren Transistoren im Ausgangszweig des Operationsverstärkers auch unter Berücksichtigung von Technologieschwankungen gewährleistet. Die Aufgabe wird erfindungsgemäß durch die Merkmale des Patentanspruchs 1 gelöst.

Die Ansprüche 2 bis 7 betreffen vorteilhafte Ausgestaltungen der Erfindung.

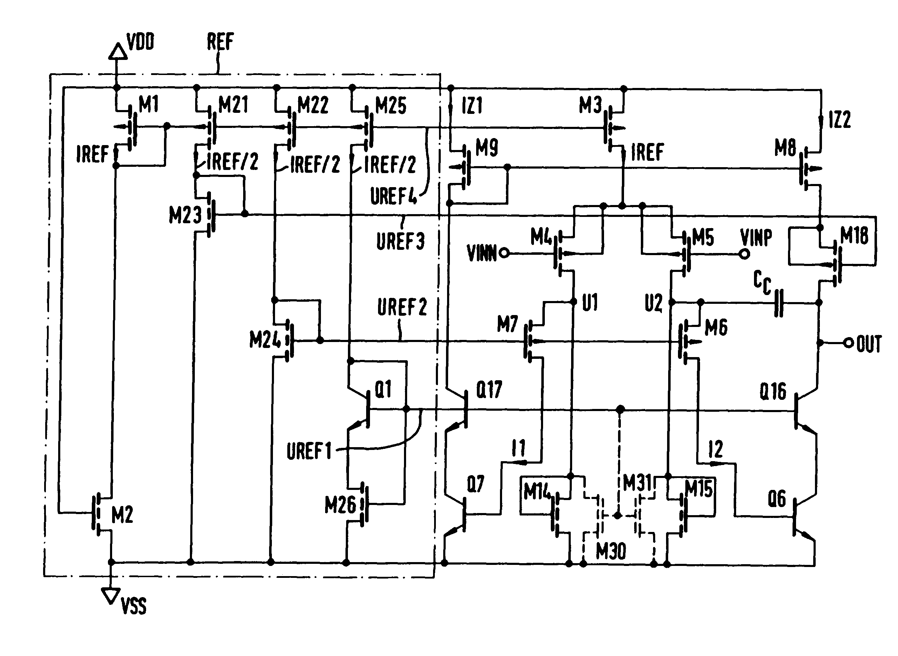

Die Erfindung wird im folgenden anhand der Zeichnung näher erläutert. Dabei zeigt die Zeichnung ein Schaltbild eines erfindungsgemäßen BiCMOS-Operationsverstärkers.

Der in der Zeichnung dargestellte erfindungsgemäße Operationsverstärker weist als Eingangsstufe eine MOS-Differenzverstärkerstufe mit zwei PMOS-Transistoren M4 und M5 auf, deren Source- und Substratanschlüsse jeweils über eine Stromquelle für einen Referenzstrom IREF mit einer Versorgungsspannung VDD verbunden sind, deren Drainanschlüsse über Lastelemente jeweils mit Bezugspotential VSS verbunden sind. Der invertierende Eingang VINN des erfindungsgemäßen Operationsverstärkers ist mit dem Gate des MOS-Transistors M4 und der nichtinvertierende Eingang des erfindungsgemäßen Operationsverstärkers ist mit dem Gate des MOS-Transistors M5 verbunden. Am Drain des MOS-Transistors M4 liegt eine erste Ausgangsspannung U1 des MOS-Differenzverstärkers und am Drain des MOS-Transistors M5 eine zweite Ausgangsspannung U2 des MOS-Differenzverstärkers an.

Der Drainanschluß des Transistors M4 ist über einen PMOS-Transistor M7, dessen Gate eine Referenzspannung UREF2 erhält, mit der Basis eines Bipolartransistors Q7 verbunden, wodurch eine Auskopplung eines Steuerstroms I1 bewirkt wird. In entsprechender Weise ist der Drainanschluß des Transistors M5 über einen PMOS-Transistor M6, dessen Gate ebenfalls mit der Referenzspannung UREF2 versorgt ist, mit der Basis eines Bipolartransistors Q6 verbunden, wodurch eine Auskopplung eines Steuerstroms I2 bewirkt wird.

Der Bipolartransistor Q7 ist Teil eines ersten Ausgangszweiges, der einen weiteren BipolarTransistor Q17, dessen Basis mit einer Referenzspannung UREF1 versorgt ist, und ein Lastelement aufweist. Entsprechend ist der Bipolartransistor Q6 Teil eines zweiten Ausgangszweiges, der zusätzlich einen Bipolartransistor Q16, dessen Basis mit einer Referenzspannung UREF1 versorgt ist, und ein weiteres Lastelement aufweist. Die Transistoren Q17 und Q7 bilden eine Kaskode, wobei der Kollektor des Transistors Q17 mit dem Lastelement, der Emitter des Transistors Q17 mit dem Kollektor des Transistors Q7 und der Emitter des Transistors Q7 mit Bezugspotential VSS verbunden sind. Die Transistoren Q16 und Q6 bilden ebenfalls eine Kaskode, wobei der Kollektor des Transistors Q16 mit dem weiteren Lastelement, der Emitter des Transistors Q16 mit dem Kollektor des Transistors Q6 und der Emitter des Transistors Q6 mit Bezugspotential VSS verbunden sind. Im ersten Ausgangszweig, der durch das Lastelement und die Transistoren Q17 und Q7 gebildet wird, fließt ein Strom IZ1 und im anderen Ausgangszweig, der durch das weitere Lastelement und die Transistoren Q16 und Q6 gebildet wird, fließt ein Strom IZ2. Der Kollektoranschluß des Transistors Q16 bildet den Ausgang OUT des erfindungsgemäßen Operationsverstärkers.

In der Regel wird der erfindungsgemäße Operationsverstärker als zweistufiger Verstärker betrieben, wobei der der MOS-Differenzverstärkerstufe zugeführte Strom IREF kleiner oder gleich groß wie die Ströme IZ1 oder IZ2 in den Ausgangszweigen ist. In diesem Fall ist eine Kompensationskapazität C_{C} zwischen dem Ausgang OUT des erfindungsgemäßen Operationsverstärkers und dem Drainanschluß des Transistors M5 des MOS-Differenzverstärkers zur Frequenzkompensation erforderlich.

Für den Fall, daß der erfindungsgemäße Operationsverstärker als einstufiger Verstärker betrieben wird, wobei der Strom IREF größer als der Strom IZ1 oder IZ2 in den Ausgangszweigen ist, ist diese Kompensationskapazität C_{C} nicht erforderlich, da infolge der in diesem Fall niederohmigeren Zweige des MOS-Differenzverstärkers, der erfindungsgemäße Operationsverstärker in seinem Frequenzverhalten durch die Verhältnisse an seinem Ausgang OUT bestimmt ist und dadurch die Frequenzkompensation durch eine am Ausgang OUT zu treibende Lastkapazität bewirkbar ist.

Die in den Zweigen des MOS-Differenzverstärkers befindlichen Lastelemente sind durch als Dioden geschaltete NMOS-Transistoren M14 bzw. M15 realisierbar, wobei jeweils ein erster Anschluß des jeweiligen NMOS-Transistors mit Bezugspotential VSS und ein jeweiliger zweiter Anschluß und ein jeweiliger Gateanschluß mit einem jeweiligen Ausgang des MOS-Differenzverstärkers verbunden sind. Die niederohmigen Dioden, die aus den Transistoren M14 und M15 gebildet sind, dienen einer zusätzlichen Arbeitspunktstabilisierung.

Zur Erzeugung einer symmetrischen Stromaufteilung in den beiden Ausgangszweigen können die Lastelemente der Ausgangszweige in Form eines Stromspiegels mit zwei PMOS-Transistoren M8 bzw. M9 ausgebildet sein, wobei der Transistor M8 zur Kaskode aus den Transistoren Q16 und Q6 und der Transistor M 9 zur Kaskode aus den Transistoren Q17 und Q7 in Reihe geschaltet ist und die Gates der beiden Transistoren M8 und M9 mit dem Kollektor des Transistors Q17 verbunden sind.

Zur Erhöhung des Ausgangslastwiderstandes des erfindungsgemäßen Operationsverstärkers kann das weitere Lastelement ein zusätzliches Lastelement enthalten. Das zusätzliche Lastelement besteht hierbei vorteilhafterweise aus einem PMOS-Transistor M18, dessen erster Anschluß mit dem Ausgang OUT des erfindungsgemäßen Operationsverstärkers, dessen Substratanschluß und zweiter Anschluß mit dem weiteren Lastelement des Ausgangszweiges verbunden sind und dessen Gateanschluß eine Referenzspannung UREF3 erhält.

Die Stromquelle für den Strom IREF ist beispielsweise durch einen PMOS-Transistor M3 realisierbar, dessen erster Anschluß mit der Versorgungsspannung VDD, dessen zweiter Anschluß mit den Sourceanschlüssen der Transistoren M4 und M5 verbunden sind und dessen Gate mit einer Referenzspannung UREF4 versorgt wird.

Die Referenzspannungen UREF1 ... UREF4 werden vorteilhafterweise in einer Referenzeinheit REF gebildet.

Die Referenzeinheit REF weist einen NMOS-Transistor M2 auf, dessen erster Anschluß mit Bezugspotential, dessen zweiter Anschluß mit Gateanschlüssen von p-Kanal-Transistoren M1, M21, M22 und M25 sowie einem ersten Anschluß des Transistors M1 verbunden ist, wobei der zweite Anschluß des Transistors M1 mit der Versorgungsspannung VDD beschaltet ist, und dessen Gate mit der Versorgungsspannung VDD verbunden ist. Der Transistor M2 arbeitet dabei im Triodengebiet und zieht über den Transistor M1 einen Referenzstrom, der möglichst im Verhältnis 1 : 1 über den Transistor M3 in die Eingangsdifferenzstufe und im Verhältnis 2 : 1 in andere Referenzspannungszweige gespiegelt wird, die jeweils einen der Transistoren M21, M22 oder M25 enthalten und von einem Strom IREF/2 durchflossen werden. Das gewählte Verhältnis 2 : 1 ist dabei unkritisch und kann etwa in einem Bereich von 1 : 1 bis 4 :1 gewählt werden.

An den Gates der Transistoren M1, M21, M22 und M25 liegt die Referenzspannung UREF4 an.

Der Transistor M21 bildet zusammen mit einem NMOS-Transistor M23 einen Referenzspannungszweig für die Referenzspannung UREF3, wobei der Drainanschluß des Transistors M21 mit dem Drainanschluß und dem Gateanschluß des Transistors M23 und der Sourceanschluß des Transistors M23 mit Bezugspotential VSS verbunden sind.

Entsprechend bildet der Transistor M22 zusammen mit einem NMOS-Transistor M24 einen Referenzspannungszweig zur Bildung der Referenzspannung UREF2, wobei der Drainanschluß des Transistors M22 mit dem Drainanschluß und dem Gateanschluß des Transistors M24 und der Sourceanschluß des Transistors M24 mit Bezugspotential VSS verbunden sind.

Der Referenzspannungszweig zur Bildung der Referenzspannung UREF1 enthält neben dem Transistor M25 einen Bipolartransistor Q1 und einen NMOS-Transistor M26, wobei der Drainanschluß des Transistors M25 mit dem Kollektor und der Basis des Bipolartransistors Q1 und dem Gate des Transistors M26 beschaltet ist und der Emitter über den Transistor M26 mit Bezugspotential VSS verbunden ist. Die Referenzspannung sollte etwa 2 U_{BE} oder kleiner, aber auf jeden Fall größer als 1 U_{BE}sein, damit Q6 und Q7 nicht in Sättigung gehen.

Wäre M26 ein Bipolartransistor, hätte man 2 U_{BE} ≈ 1,7 V. Da der Verstärker aber beispielsweise nur mit 3,3 V arbeitet, ist es sinnvoll UREF1 kleiner zu wählren um den Aussteuerbereich zu vergrößern. Durch den MOS-Transistor M26 kann UREF1 im angegebenen Bereich über Weiten/Längen-Verhältnis eingestellt werden und beträgt beispielsweise 1,1 V.

Die Referenzspannung UREF1 ist am Gate des Transistors M26, die Referenzspannung UREF2 am Gate des Transistors M24, die Referenzspannung UREF3 am Gate des Transistors M23 abgreifbar.

Eine weitere Variante, bei der ein Teil der Diodenströme über parallel geschaltete NMOS-Stromquellen geführt wird, um den gesamten Lastwiderstand etwas zu erhöhen, ist in der Zeichnung durch die gestrichelt gezeichneten NMOS-Transistoren M30 und M31 angedeutet.

Der Transistor M30 ist dabei zum Transistor M14 und der Transistor M31 zum Transistor M15 parallelgeschaltet und die Gates der Transistoren M30 und M31 sind auf eine Referenzspannung, hier beispielsweise auf UREF1, gelegt.

Dadurch, daß weniger STrom über die Dioden fließt, kann im Weiten/Länger-Verhältnis verkleinert werden, wodurch der Widerstand steigt. Die parallelen Stromquellen sind wesentlich hochohmiger, so daß die Parallelschaltung immer noch hochohmiger ist als die Dioden alleine.

## Patentansprüche

1. BiCMOS-Operationsverstärker für Schalter-Kondensator-Schaltungen,
bei dem eine MOS-Differenzverstärkerstufe (M4, M5) vorgesehen ist, die durch eine Stromquelle mit einem Referenzstrom (IREF) versorgt ist und die in jedem der beiden Zweige der MOS-Differenzverstärkerstufe ein Lastelement (M14, M15) aufweist, und
bei dem zwei Ausgangszweige vorgesehen sind, die jeweils aus einer Reihenschaltung aus einem weiteren Lastelement (M9, M8) und zwei bipolaren Transistoren (Q17, Q7 und Q16, Q6) bestehen, wobei die jeweiligen Bipolartransistoren eine Kaskode bilden, bei der jeweils die Basis eines Bipolartransistors mit einer ersten Referenzspannung (UREF1) versorgt ist und eines der weiteren Lastelemente mit einem Ausgang (OUT) des Operationsverstärkers verbunden ist,
**dadurch gekennzeichnet,**
daß jeweils ein Bipolartransistor (Q7 bzw. Q6) einer jeweiligen Kaskode (Q7, Q17 bzw. Q6, Q16) über einen jeweiligen PMOS-Transistor (M6 bzw. M7), dessen jeweiliges Gate mit einer zweiten Referenzspannung (UREF2) beaufschlagt ist, direkt von einer Spannung (U1, U2) am Lastelement des jeweiligen Zweiges der MOS-Differenzverstärkerstufe ansteuerbar ist.

2. BiCMOS-Operationsverstärker nach Anspruch 1,
bei dem der Referenzstrom (IREF) durch die MOS-Differenzverstärkerstufe so gewählt ist, daß er kleiner oder gleich den jeweiligen Strömen (IZ1, IZ2) in den Ausgangszweigen ist, und bei dem der Ausgang (OUT) des Operationsverstärkers über eine Kompensationskapazität (C_{C}) auf einen Ausgang der MOS-Differenzverstärkerstufe rückgekoppelt ist.

3. BiCMOS-Operationsverstärker nach Anspruch 1 oder 2,
bei dem die Lastelemente in den Ausgangszweigen jeweils einen Transistor (M8, M9) aufweisen und diese Transistoren in Form eines Stromspiegels beschaltet sind und bei dem das mit dem Ausgang (OUT) des Operationsverstärkers verbundene Lastelement ein zusätzliches Lastelement (M18) aufweist, das zum jeweiligen Transistor des Stromspiegels in Reihe geschaltet ist.

4. BiCMOS-Operationsverstärker nach Anspruch 3,
bei dem das zusätzliche Lastelement aus einem MOS-Transistor (M18) besteht, dessen Gate durch eine dritte Referenzspannung (UREF3) ansteuerbar ist.

5. BiCMOS-Operationsverstärker nach einem der Ansprüche 1 bis 4,
bei dem die Stromquelle für den Referenzstrom (IREF) aus einem PMOS-Transistor (M3) besteht, dessen Gate durch eine vierte Referenzspannung (UREF4) ansteuerbar ist.

6. BiCMOS-Operationsverstärker nach Anspruch 5,
bei dem die erste, zweite, dritte und vierte Referenzspannung in einer Referenzeinheit (REF) bildbar ist, die derart aufgebaut ist, daß die erste Referenzspannung (UREF1) an der Basis eines Bipolartransistors (Q1) anliegt, dessen Emitter über einen ersten NMOS-Transistor (M26) mit Bezugspotential (VSS), dessen Kollektor über einen ersten PMOS-Transistor (M25) mit einer Versorgungsspannung (VDD) und dessen Basis mit dem Kollektor des Bipolartransistors und dem Gate des ersten NMOS-Transistors verbunden sind,
daß die zweite Referenzspannung (UREF2) am Gate eines zweiten NMOS-Transistors (M24) anliegt, dessen erster Anschluß direkt mit Bezugspotential, dessen zweiter Anschluß über einen zweiten PMOS-Transistor (M22) mit der Versorgungsspannung und dessen Gate mit dem zweiten Anschluß des zweiten NMOS-Transistors beschaltet sind,
daß die dritte Referenzspannung (UREF3) am Gate eines dritten NMOS-Transistors (M23) anliegt, dessen erster Anschluß direkt mit Bezugspotential, dessen zweiter Anschluß über einen dritten PMOS-Transistor (M21) mit der Versorgungsspannung (VDD) und dessen Gate mit dem zweiten Anschluß des dritten NMOS-Transistors verbunden sind, und
daß die vierte Referenzspannung (UREF4) an den Gates des ersten, zweiten, dritten und eines vierten PMOS-Transistors (M1) anliegt, dessen erster Anschluß direkt mit der Versorgungsspannung, dessen zweiter Anschluß über einen vierten NMOS-Transistor (M2) mit Bezugspotential und dessen Gate mit dem zweiten Anschluß des vierten PMOS-Transistors beschaltet sind, wobei das Gate des vierten NMOS-Transistors mit der Versorgungsspannung verbunden ist.

7. BiCMOS-Operationsverstärker nach einem der vorhergehenden Ansprüche,
bei dem die Lastelemente in den Zweigen des MOS-Differenzverstärkers aus NMOS-Transistoren (M14, M15) bestehen, die als Dioden geschaltet sind.

## Claims

1. BiCMOS operational amplifier for switch/capacitor circuits,
in which there is provided an MOS differential amplifier stage (M4, M5), which is supplied with a reference current (IREF) by a current source and which has a load element (M14, M15) in each of the two paths of the MOS differential amplifier stage, and
in which two output paths are provided which each comprise a series circuit formed by a further load element (M9, M8) and two bipolar transistors (Q17, Q7 and Q16, Q6), the respective bipolar transistors forming a cascode,
in which the base of each bipolar transistor is supplied with a first reference voltage (UREF1) and one of the further load elements is connected to an output (OUT) of the operational amplifier,
characterized
in that a respective bipolar transistor (Q7 or Q6) of a respective cascode (Q7, Q17 or Q6, Q16) can be driven, via a respective PMOS transistor (M6 or M7) to whose respective gate a second reference voltage (UREF2) is applied, directly by a voltage (U1, U2) across the load element of the respective path of the MOS differential amplifier stage.

2. BiCMOS operational amplifier according to Claim 1,
in which the reference current (IREF) through the MOS differential amplifier stage is selected such that it is less than or equal to the respective currents (IZ1, IZ2) in the output paths, and in which the output (OUT) of the operational amplifier is fed back to an output of the MOS differential amplifier stage via a compensation capacitance (C_{C}).

3. BiCMOS operational amplifier according to Claim 1 or 2,
in which the load elements in the output paths each have a transistor (M8, M9) and these transistors are connected in the form of a current mirror, and in which the load element connected to the output (OUT) of the operational amplifier has an additional load element (M18) which is connected in series with the respective transistor of the current mirror.

4. BiCMOS operational amplifier according to Claim 3,
in which the additional load element consists of an MOS transistor (M18) whose gate can be driven by a third reference voltage (UREF3).

5. BiCMOS operational amplifier according to one of Claims 1 to 4,
in which the current source for the reference current (IREF) consists of a PMOS transistor (M3) whose gate can be driven by a fourth reference voltage (UREF4).

6. BiCMOS operational amplifier according to Claim 5,
in which the first, second, third and fourth reference voltages can be formed in a reference unit (REF) which is constructed in such a way that the first reference voltage (UREF1) is applied to the base of a bipolar transistor (Q1), the emitter of which transistor (Q1) is connected to the reference potential (VSS) via a first NMOS transistor (M26), the collector of which transistor (Q1) is connected to a supply voltage (VDD) via a first PMOS transistor (M25), and the base of which transistor (Q1) is connected to the collector of the bipolar transistor and to the gate of the first NMOS transistor,
that the second reference voltage (UREF2) is applied to the gate of a second NMOS transistor (M24), the first terminal of which transistor (M24) is connected directly to the reference potential, the second terminal of which transistor (M24) is connected to the supply voltage via a second PMOS transistor (M22), and the gate of which transistor (M24) is connected to the second terminal of the second NMOS transistor,
that the third reference voltage (UREF3) is applied to the gate of a third NMOS transistor (M23), the first terminal of which transistor (M23) is connected directly to the reference potential, the second terminal of which transistor (M23) is connected to the supply voltage (VDD) via a third PMOS transistor (M21), and the gate of which transistor (M23) is connected to the second terminal of the third NMOS transistor, and that the fourth reference voltage (UREF4) is applied to the gates of the first, second and third PMOS transistors and of a fourth PMOS transistor (M1), the first terminal of which transistor (M1) is connected directly to the supply voltage, the second terminal of which transistor (M1) is connected to the reference potential via a fourth NMOS transistor (M2), and the gate of which transistor (M1) is connected to the second terminal of the fourth PMOS transistor, the gate of the fourth NMOS transistor being connected to the supply voltage.

7. BiCMOS operational amplifier according to one of the preceding claims,
in which the load elements in the paths of the MOS differential amplifier comprise NMOS transistors (M14, M15) which are connected as diodes.

## Revendications

1. Amplificateur opérationnel BiCMOS pour montages commutateur/condensateur,
dans lequel il est prévu un étage amplificateur différentiel MOS (M4, M5) qui est alimenté d'un courant de référence (IREF) par une source de courant et qui présente un élément de charge (M14, M15) dans chacune des deux branches de l'étage amplificateur différentiel MOS, et
dans lequel sont prévues deux branches de sortie qui sont constituées chacune d'un circuit série composé d'un autre élément de charge (M9, M8) et de deux transistors bipolaires (Q17, Q7 et Q16, Q6), les transistors bipolaires formant dans chaque cas une cascode dans laquelle, à chaque fois la base d'un transistor bipolaire est alimentée avec une première tension de référence (UREF1) et l'un des autres éléments de charge est connecté à une sortie (OUT) de l'amplificateur opérationnel,
caractérisé
en ce qu'à chaque fois un transistor bipolaire (Q7 resp. Q6) d'une cascode respective (Q7, Q17 resp. Q6, Q16) peut être directement commandé, à travers un transistor PMOS respectif (M6 resp. M7) dont la grille respective est alimentée d'une deuxième tension de référence (UREF2), par une tension (U1, U2) à l'élément de charge de la branche respective de l'étage amplificateur différentiel MOS.

2. Amplificateur opérationnel BiCMOS selon la revendication 1, dans lequel le courant de référence (IREF) est choisi par l'étage amplificateur différentiel MOS de manière à être inférieur ou égal aux courants respectifs (IZ1, IZ2) circulant dans les branches de sortie, et dans lequel la sortie (OUT) de l'amplificateur opérationnel est réinjectée à travers une capacité de compensation (C_{C}) sur une sortie de l'étage amplificateur différentiel MOS.

3. Amplificateur opérationnel BiCMOS selon la revendication 1 ou 2, dans lequel les éléments de charge dans les branches de sortie présentent chacun un transistor (M8, M9) et ces transistors sont branchés sous la forme d'un miroir de courant, et dans lequel l'élément de charge connecté à la sortie (OUT) de l'amplificateur opérationnel présente un élément de charge additionnel (M18) qui est branché en série avec le transistor correspondant du miroir de courant.

4. Amplificateur opérationnel BiCMOS selon la revendication 3, dans lequel l'élément de charge additionnel est constitué d'un transistor MOS (M18) dont la grille peut être commandée par une troisième tension de référence (UREF3).

5. Amplificateur opérationnel BiCMOS selon une des revendications 1 à 4, dans lequel la source de courant pour le courant de référence (IREF) est constituée d'un transistor PMOS (M3) dont la grille peut être commandée par une quatrième tension de référence (UREF4)

6. Amplificateur opérationnel BiCMOS selon la revendication 5, dans lequel la première, deuxième, troisième et quatrième tension de référence peut être formée dans une unité de référence (REF) qui est construite de manière que la première tension de référence (UREF1) soit appliquée à la base d'un transistor bipolaire (Q1) dont l'émetteur est connecté, à travers un premier transistor NMOS (M26) possédant un potentiel de référence (VSS), dont le collecteur est connecté à une tension d'alimentation (VDD) à travers un premier transistor PMOS (M25) et dont la base est connectée au collecteur du transistor bipolaire et à la grille du premier transistor NMOS,
de manière que la deuxième tension de référence (UREF2) soit appliquée à la grille d'un deuxième transistor NMOS (M24) dont la première connexion est branchée directement au potentiel de référence, dont la deuxième connexion est branchée sur la tension d'alimentation à travers un deuxième transistor PMOS (M22) et dont la grille est branchée sur la deuxième connexion du deuxième transistor NMOS,
de manière que la troisième tension de référence (UREF3) soit appliquée à la grille d'un troisième transistor NMOS (M23) dont la première connexion est connectée directement au potentiel de référence, dont la deuxième connexion est connectée à la tension d'alimentation (VDD) à travers un troisième transistor PMOS (M21) et dont la grille est connectée à la deuxième connexion du troisième transistor NMOS, et
de manière que la quatrième tension de référence (UREF4) soit appliquée aux grilles du premier, deuxième, troisième et d'un quatrième transistor PMOS (M1) dont la première connexion est connectée directement à la tension d'alimentation, dont la deuxième connexion est connectée à travers un quatrième transistor NMOS (M2) avec un potentiel de référence et dont la grille est connectée à la deuxième connexion du quatrième transistor PMOS, la grille du quatrième transistor NMOS étant connectée à la tension d'alimentation.

7. Amplificateur opérationnel BiCMOS selon une des revendications précédentes, dans lequel les éléments de charge dans les branches de l'amplificateur différentiel MOS sont constitués des transistors NMOS (M14, M15) qui sont branchés en diodes.
